(19) Europäisches Patentamt / European Patent Office / Office européen des brevets

(11) **EP 3 537 860 B1**

(12) **EUROPEAN PATENT SPECIFICATION**

(45) Date of publication and mention
of the grant of the patent:
**26.10.2022 Bulletin 2022/43**

(21) Application number: **17866650.9**

(22) Date of filing: **02.11.2017**

(51) International Patent Classification (IPC):
*H05K 9/00* (2006.01)   *C08J 7/043* (2020.01)
*C08J 7/044* (2020.01)   *C08J 7/046* (2020.01)
*B32B 25/02* (2006.01)   *B32B 25/14* (2006.01)
*C08K 3/22* (2006.01)   *C08L 21/00* (2006.01)

(52) Cooperative Patent Classification (CPC):
**H05K 9/0075; B32B 25/02; B32B 25/14;
C08J 7/043; C08J 7/044; C08J 7/046; C08K 3/22;
C08L 21/00**

(86) International application number:
**PCT/JP2017/039697**

(87) International publication number:
**WO 2018/084235 (11.05.2018 Gazette 2018/19)**

(54) **ELECTROMAGNETIC WAVE ABSORPTION SHEET**

ELEKTROMAGNETISCHE WELLENABSORPTIONSSCHICHT

FEUILLE D'ABSORPTION D'ONDE ÉLECTROMAGNÉTIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.11.2016   JP 2016216291**

(43) Date of publication of application:
**11.09.2019   Bulletin 2019/37**

(73) Proprietor: **Maxell, Ltd.
Kyoto 618-8525 (JP)**

(72) Inventors:
  • **HIROI, Toshio
    Kyoto 618-8525 (JP)**
  • **FUJITA, Masao
    Kyoto 618-8525 (JP)**

(74) Representative: **Diehl & Partner
Patent- und Rechtsanwaltskanzlei mbB
Erika-Mann-Straße 9
80636 München (DE)**

(56) References cited:
  JP-A- 2004 186 371   JP-A- 2004 186 371
  JP-A- 2008 277 726   JP-A- 2009 188 322
  JP-A- 2009 188 322   JP-A- 2013 201 359
  JP-A- 2013 201 359   US-A- 5 275 880
  US-A1- 2010 238 063

**Description**

Technical Field

The present disclosure relates to an electromagnetic-wave absorbing sheet for absorbing electromagnetic waves, in particular, an electromagnetic-wave absorbing sheet that contains an electromagnetic-wave absorbing material for absorbing electromagnetic waves by magnetic resonance to absorb electromagnetic waves of high frequencies in a frequency band equal to or higher than a millimeter-wave band while having elasticity of elongating in an in-plane direction.

Background Art

Electromagnetic-wave absorbing sheets for absorbing electromagnetic waves have been used to exclude influences of leaked electromagnetic waves to be emitted to the outside from an electric circuit or the like and influences of undesirably reflected electromagnetic waves.

Recently, researches on technologies of utilizing high frequency electromagnetic waves, including centimeter waves having a frequency of several gigahertz (GHz), millimeter waves having a frequency of 30 GHz to 300 GHz, and electromagnetic waves having a still higher frequency of one terahertz (THz) as electromagnetic waves in a high frequency band above the millimeter-wave band, have proceeded for mobile communications such as mobile phones, wireless LAN and electric toll collection system (ETC).

In response to such a technical trend of utilizing electromagnetic waves of high frequencies, there is a growing demand that electromagnetic-wave absorbers and electromagnetic-wave absorbing sheets for absorbing unnecessary electromagnetic waves absorb electromagnetic waves in higher frequency bands from the gigahertz band to the terahertz band.

As electromagnetic-wave absorbers for absorbing electromagnetic waves in the high frequency band equal to or higher than the millimeter-wave band, Patent Document 1 proposes an electromagnetic-wave absorber that has a packing structure of particles having epsilon iron oxide ($\varepsilon$-Fe$_2$O$_3$) crystal in the magnetic phase, wherein the epsilon iron oxide exhibits an electromagnetic-wave absorbing performance in a range from 25 to 100 GHz. Patent Document 2 proposes a sheet-shaped oriented body that is produced by mixing and kneading fine epsilon iron oxide particles with a binder, and applying a magnetic field to the mixture from the outside during dry curing of the binder to improve the magnetic field orientation of the epsilon iron oxide particles.

Patent Document 3 proposes an elastic electromagnetic-wave absorbing sheet that can absorb centimeter waves, wherein carbon nanotubes are dispersed in silicone rubber.

Patent Document 4 proposes a low-cost electromagnetic-wave absorbing sheet that can absorb electromagnetic waves in a frequency band of 75 to 77 GHz while raising profitability as general use, wherein silicon carbide powder dispersed in a rubber matrix resin is arranged on the surface of a metal body. Patent Document 5 proposes an electromagnetic-wave shielding adhesive sheet to be attached to a flexible printed-wiring board to shield electromagnetic waves from the outside, wherein a conductive layer containing conductive fine particles and an insulating layer are stacked. By keeping the repulsion force of the sheet within a predetermined range, the sheet can have flexibility of being bent together with the flexible printed-wiring board and heat resistance. Patent Document 6 proposes an electromagnetic-wave absorbing sheet comprising an electromagnetic-wave absorbing layer that contains a magnetic iron oxide that magnetically resonates in a frequency band equal to or higher than a millimeter-wave band as an electromagnetic-wave absorbing material and a rubber binder. Patent Document 7 proposes an electromagnetic-wave absorbing sheet comprising an electromagnetic-wave absorbing layer that contains a metal powder that magnetically resonates as an electromagnetic-wave absorbing material and a rubber binder, wherein the electromagnetic-wave absorbing sheet has a maximum elongation percentage of an elastic region in one in-plane direction of 20% to 200%.

Prior Art Documents

Patent Documents

Patent Document 1: JP 2008-060484 A
Patent Document 2: JP 2016-135737 A
Patent Document 3: JP 2011-233834 A
Patent Document 4: JP 2005-057093 A
Patent Document 5: JP 2013-004854 A
Patent Document 6: US 2010/238063 A1

Patent Document 7: JP 2004-186371 A

Disclosure of Invention

Problem to be Solved by the Invention

In order to shield electromagnetic waves leaking from an electromagnetic-wave generation source, it is necessary to arrange an electromagnetic-wave absorber on a housing or the like that covers a target circuit component. Especially when the shape of the arrangement position is not flat, an electromagnetic-wave absorbing sheet having flexibility and elasticity of elongating in an in-plane direction is more conveniently and suitably used than a bulky electromagnetic-wave absorber.

However, for example, the electromagnetic-wave absorbing sheet disclosed in Patent Document 3 cannot absorb electromagnetic waves in a frequency band of several tens of GHz or higher (millimeter-wave band). The electromagnetic-wave absorbing sheet disclosed in Patent Document 4 is stacked on the non-stretchable metal body, and the adhesive sheet disclosed in Patent Document 5 is attached to the flexible printed-wiring board by thermocompression bonding. Therefore, neither of the sheets has elasticity.

As electromagnetic-wave absorbing members that can absorb electromagnetic waves in a frequency band of several tens of GHz or higher (millimeter-wave band), electromagnetic-wave absorbing sheets having elasticity have not yet been realized.

In order to solve the conventional problems, it is an object of the present disclosure to provide an electromagnetic-wave absorbing sheet that can favorably absorb electromagnetic waves of high frequencies in a frequency band equal to or higher than the millimeter-wave band while having elasticity of elongating in an in-plane direction.

Means for Solving Problem

An electromagnetic-wave absorbing sheet according to claim 1 and an electromagnetic-wave absorbing sheet according to claim 9.

Effects of the Invention

Since the electromagnetic-wave absorbing layer of the electromagnetic-wave absorbing sheet according to claim 1 disclosed in the present application contains a magnetic iron oxide that magnetically resonates in a high frequency band equal to or higher than the millimeter-wave band as an electromagnetic-wave absorbing material, the sheet can convert electromagnetic waves in the high frequency band equal to or higher than several tens of GHz into heat to absorb the electromagnetic waves. Moreover, since the electromagnetic-wave absorbing sheet contains a rubber binder and has a maximum elongation percentage in an elastic region in an in-plane direction of 20% to 200%, the sheet can be easily arranged on a desired portion and even cover a movable part.

Brief Description of Drawings

[FIG. 1] FIG. 1 is a cross-sectional view illustrating the configuration of an electromagnetic-wave absorbing sheet of Embodiment 1.

[FIG. 2] FIG. 2 is a graph illustrating electromagnetic-wave absorbing properties of epsilon iron oxide in which part of the Fe site is substituted.

[FIG. 3] FIG. 3 is a graph illustrating an elongation of an electromagnetic-wave absorbing sheet that includes an electromagnetic-wave absorbing layer containing a rubber binder, when a tensile stress is externally applied to the sheet. FIG. 3A illustrates a change in the elongation percentage of an electromagnetic-wave absorbing sheet that ruptures when exceeding the maximum elongation percentage. FIG. 3B illustrates a change in the elongation percentage of an electromagnetic-wave absorbing sheet that causes plastic deformation when exceeding the maximum elongation percentage.

[FIG. 4] FIG. 4 is a graph illustrating a relationship between the tensile stress applied externally and the elongation percentage in electromagnetic-wave absorbing sheets of examples.

[FIG. 5] FIG. 5 is a graph illustrating a change in the electromagnetic-wave absorbing properties of the electromagnetic-wave absorbing sheet of Embodiment 1 by elongation.

[FIG. 6] FIG. 6 is a graph illustrating a relationship between the thickness and the electromagnetic-wave absorption amount of the electromagnetic-wave absorbing sheet of Embodiment 1.

[FIG. 7] FIG. 7 is a cross-sectional view illustrating the configuration of an electromagnetic-wave absorbing sheet of Embodiment 2.

[FIG. 8] FIG. 8 is a graph illustrating a change in the electromagnetic-wave absorbing properties according to a change in the elongation percentage of the electromagnetic-wave absorbing sheet of Embodiment 2.

[FIG. 9] FIG. 9 is a graph illustrating a relationship between the thickness and the electromagnetic-wave attenuation amount of the electromagnetic-wave absorbing sheet of Embodiment 2.

Description of the Invention

An electromagnetic-wave absorbing sheet according to claim 1 disclosed in the present application is an electromagnetic-wave absorbing sheet including an electromagnetic-wave absorbing layer that contains a magnetic iron oxide that magnetically resonates in a frequency band equal to or higher than a millimeter-wave band as an electromagnetic-wave absorbing material and a rubber binder. The electromagnetic-wave absorbing sheet has a maximum elongation percentage of an elastic region in one in-plane direction of 20% to 200%.

With this configuration, the electromagnetic-wave absorbing sheet disclosed in the present application can absorb electromagnetic waves in a high frequency band equal to or higher than 30 GHz (millimeter-wave band) by the magnetic resonance of the magnetic iron oxide contained as the electromagnetic-wave absorbing material. Moreover, by using the electromagnetic-wave absorbing material and the rubber binder, it is possible to provide a highly elastic electromagnetic-wave absorbing sheet having a maximum elongation percentage in an in-plane direction of 20% to 200%. Because of this, in an arrangement of the electromagnetic-wave absorbing sheet on a housing or the like that contains an electric circuit to be shielded, the electromagnetic-wave absorbing sheet can be easily handled and easily arranged even on a complicatedly curved surface. Moreover, the electromagnetic-wave absorbing sheet can cover a movable part of a member that changes its shape (e.g., joint part of an arm member) to prevent undesired emission and penetration of electromagnetic waves.

In the electromagnetic-wave absorbing sheet disclosed in the present application, it is preferred that the magnetic iron oxide is epsilon iron oxide. By using, as the electromagnetic-wave absorbing material, epsilon iron oxide that absorbs electromagnetic waves with frequencies higher than 30 GHz, it is possible to provide an electromagnetic-wave absorbing sheet that absorbs high frequency electromagnetic waves.

In this case, it is preferred that part of a Fe site of the epsilon iron oxide is substituted with a trivalent metal atom. Thereby, it is possible to provide an electromagnetic-wave absorbing sheet that absorbs electromagnetic waves in a desired frequency band by taking advantage of the characteristics of epsilon iron oxide exhibiting different magnetic resonance frequencies depending on a material substituting for the Fe site.

Further, it is preferred that a volume content of the magnetic iron oxide in the electromagnetic-wave absorbing layer is 30% or more. By doing so, it is possible to increase a value of a permeability imaginary part ($\mu''$) of the electromagnetic-wave absorbing layer, and thus provide an electromagnetic-wave absorbing sheet with high electromagnetic-wave absorbing properties.

Further, it is preferred that the rubber binder is acrylic rubber or silicone rubber. By using a rubber material having high heat resistance, it is possible to provide an electromagnetic-wave absorbing sheet with high reliability.

Further, it is preferred that an input impedance of the electromagnetic-wave absorbing layer in a state of being stretched by 5% to 75 % of the maximum elongation percentage of the elastic region is matched to an impedance in the air. By doing so, the input impedance can be close to the impedance in the air in a wide range of the elongation percentage of the electromagnetic-wave absorbing sheet, whereby the electromagnetic-wave absorbing sheet can maintain high electromagnetic-wave absorbing properties.

Further, according to claim 1 the input impedance of the electromagnetic-wave absorbing layer when stretched within a range of the elastic region is in a range from 360 $\Omega$ to 450 $\Omega$. By doing so, it is possible to avoid a situation that the input impedance largely differs from the impedance in the air when the electromagnetic-wave absorbing sheet elongates and contracts within the elastic region, whereby the electromagnetic-wave absorbing sheet can exhibit electromagnetic-wave absorbing properties of a certain level or higher.

Further, it is preferred that the electromagnetic-wave absorbing sheet according to claim 1 disclosed in the present application further includes a reflective layer that is formed in contact with one surface of the electromagnetic-wave absorbing layer to reflect electromagnetic waves passing through the electromagnetic-wave absorbing layer. By doing so, it is possible to provide a reflection-type electromagnetic-wave absorbing sheet that can reliably shield and absorb electromagnetic waves in the high frequency band equal to or higher than the millimeter-wave band.

It is preferred that the electromagnetic-wave absorbing sheet further includes an adhesive layer to make the electromagnetic-wave absorbing sheet attachable. By doing so, it is possible to provide an electromagnetic-wave absorbing sheet having high electromagnetic-wave absorbing properties while having excellent handleability of being easily arranged on a desired place.

A second electromagnetic-wave absorbing sheet according to claim 9 disclosed in the present application includes: an electromagnetic-wave absorbing layer containing an electromagnetic-wave absorbing material and a rubber binder; and a reflective layer that is formed in contact with one surface of the electromagnetic-wave absorbing layer to reflect electromagnetic waves passing through the electromagnetic-wave absorbing layer. The electromagnetic-wave absorbing material is a magnetic iron oxide that magnetically resonates with electromagnetic waves of a predetermined frequency. An input impedance of the electromagnetic-wave absorbing layer in a state of being stretched in one in-plane direction is matched to an impedance in the air.

The second electromagnetic-wave absorbing sheet disclosed in the present application is configured on the assumption that the electromagnetic-wave absorbing sheet is stretched to a certain extent in the practical use. Therefore, it is possible to match the input impedance to the impedance in the air in the wide range of the elongation percentage, and thus improve the electromagnetic-wave absorbing properties of the elastic electromagnetic-wave absorbing sheet in the practical use.

Hereinafter, the electromagnetic-wave absorbing sheet disclosed in the present application will be described with reference to the drawings.

The term "electric waves" can be understood as one type of electromagnetic waves in a broader sense, and therefore the present specification uses the term "electromagnetic waves" instead. For example, an electric-wave absorber is called an electromagnetic-wave absorber in the present specification.

(Embodiment 1)

An electromagnetic-wave absorbing sheet of Embodiment 1 according to claim 1 disclosed in the present application is a transmission-type electromagnetic-wave absorbing sheet that is not provided with a reflective layer for reflecting electromagnetic waves incident upon the electromagnetic-wave absorbing sheet.

[Sheet Configuration]

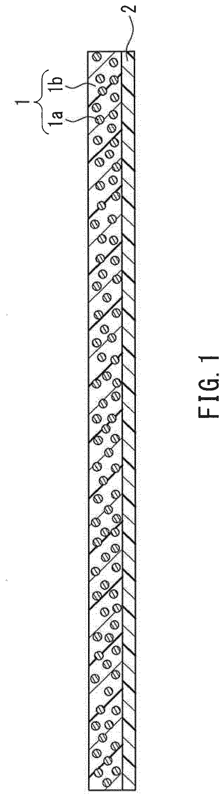

FIG. 1 is a cross-sectional view illustrating the configuration of the electromagnetic-wave absorbing sheet according to Embodiment 1 of the present application.

FIG. 1 is illustrated for the sake of easy understanding of the configuration of the electromagnetic-wave absorbing sheet of this embodiment, and does not faithfully reflect the actual sizes or thicknesses of members illustrated therein.

The electromagnetic-wave absorbing sheet exemplified in this embodiment includes an electromagnetic-wave absorbing layer 1 that contains a magnetic iron oxide 1a (particulate electromagnetic-wave absorbing material) and a rubber binder 1b. In the electromagnetic-wave absorbing sheet illustrated in FIG. 1, an adhesive layer 2 is formed on the back surface side (lower side in FIG. 1) of the electromagnetic-wave absorbing layer 1. The adhesive layer 2 makes the electromagnetic-wave absorbing sheet attachable to a predetermined position such as an inner surface or outer surface of a housing of an electric device.

In the electromagnetic-wave absorbing sheet of this embodiment, the magnetic iron oxide 1a contained in the electromagnetic-wave absorbing layer 1 resonates magnetically, and converts electromagnetic waves into heat energy by magnetic loss to absorb the electromagnetic waves. Therefore, the electromagnetic-wave absorbing sheet of this embodiment can be used as a transmission-type electromagnetic-wave absorbing sheet that is not provided with a reflective layer on one surface of the electromagnetic-wave absorbing layer 1 and that absorbs electromagnetic waves passing through the electromagnetic-wave absorbing layer 1.

In the electromagnetic-wave absorbing sheet of this embodiment, various kinds of rubber materials can be used as the binder 1b constituting the electromagnetic-wave absorbing layer 1. Because of this, particularly it is possible to obtain an electromagnetic-wave absorbing sheet that elongates and contracts easily in an in-plane direction of the electromagnetic-wave absorbing sheet. Since the electromagnetic-wave absorbing layer of the electromagnetic-wave absorbing sheet of this embodiment is formed so that the rubber binder 1b contains the magnetic iron oxide 1a, the electromagnetic-wave absorbing sheet can be highly flexible while being highly elastic, whereby the sheet can be rolled up in handling and easily arranged along a curved surface.

Moreover, in the electromagnetic-wave absorbing sheet of this embodiment, the adhesive layer 2 is stacked on one surface of the electromagnetic-wave absorbing layer 1 so that the sheet can be easily attached to a desired position such as a surface of a member located around a generation source of high frequency electromagnetic waves. Note that the electromagnetic-wave absorbing sheet of this embodiment does not necessarily include the adhesive layer 2.

[Electromagnetic-wave absorbing material]

In the electromagnetic-wave absorbing sheet of this embodiment, the electromagnetic-wave absorbing material may be powder of a magnetic iron oxide, including epsilon iron oxide magnetic powder, barium ferrite magnetic powder, and strontium ferrite magnetic powder. Among these, epsilon iron oxide is particularly preferred as the electromagnetic-wave absorbing material, because the electrons of the iron atoms precess at high frequencies in spin motion, and epsilon iron oxide has a high effect of absorbing electromagnetic waves of 30 to 300 GHz (millimeter-wave band) or even higher frequencies.

The epsilon phase of epsilon iron oxide ($\varepsilon$-Fe$_2$O$_3$) is a phase that appears between the alpha phase ($\alpha$-Fe$_2$O$_3$) and the gamma phase ($\gamma$-Fe$_2$O$_3$) in ferric oxide (Fe$_2$O$_3$). Epsilon iron oxide is a magnetic material that can be obtained, in a single phase state, by a nanoparticle synthesis method that combines a reverse micelle method and a sol-gel method.

Epsilon iron oxide is a fine particle of several nm to several tens of nm but has the largest coercive force, among metal oxides, of about 20 kOe at room temperature; besides, the natural magnetic resonance by a gyromagnetic effect based on the precession is caused in a frequency band of several tens of GHz or higher (millimeter-wave band).

In epsilon iron oxide, by substituting part of the Fe site of the crystal with a trivalent metal element such as aluminum (Al), gallium (Ga), rhodium (Rh) or indium (In), it is possible to change a magnetic resonance frequency, i.e., a frequency of electromagnetic waves to be absorbed, when epsilon iron oxide is used as the electromagnetic-wave absorbing material.

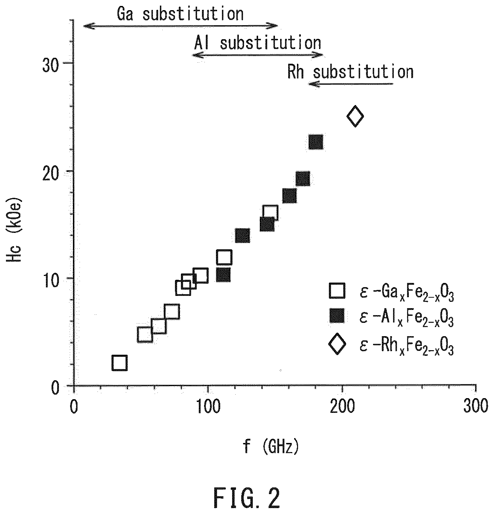

FIG. 2 shows a relationship between a coercive force Hc of epsilon iron oxide and a natural resonance frequency f when the metal element substituting for the Fe site is changed. The natural resonance frequency f coincides with the frequency of electromagnetic waves to be absorbed.

FIG. 2 indicates that epsilon iron oxides in which part of the Fe site is substituted have different natural resonance frequencies depending on the type of the substituted metal element and the substitution amount. Moreover, the coercive force of epsilon iron oxide increases in keeping with the natural resonance frequency.

More specifically, epsilon iron oxide substituted with gallium ($\varepsilon$-Ga$_x$Fe$_{2-x}$O$_3$) has an absorption peak in a frequency band from about 30 GHz to 150 GHz with adjustment of the substitution amount "x". Epsilon iron oxide substituted with aluminum ($\varepsilon$-Al$_x$Fe$_{2-x}$O$_3$) has an absorption peak in a frequency band from about 100 GHz to 190 GHz with adjustment of the substitution amount "x". Therefore, the frequency of electromagnetic waves to be absorbed can be set to a desired value by selecting the type of the element substituting for the Fe site of epsilon iron oxide and adjusting the substitution amount of Fe so that the natural resonance frequency of the epsilon iron oxide will be a desired frequency to be absorbed by the electromagnetic-wave absorbing sheet. Further, in the case of using epsilon iron oxide substituted with rhodium ($\varepsilon$-Rh$_x$Fe$_{2-x}$O$_3$), it is possible to shift a frequency band of electromagnetic waves to be absorbed to an even higher direction of 180 GHz or higher.

Epsilon iron oxides such as those in which part of the Fe site is substituted with metal are on the market and can be obtained easily. Epsilon iron oxide powder preferably has an average particle size of 5 nm to 50 nm and has a substantially spherical shape or short rod shape (bar shape).

Barium ferrite (BaFe$_{12}$O$_{19}$) and strontium ferrite (SrFe$_{12}$O$_{19}$) are both hexagonal ferrite, and have magnetic anisotropy and thus have a large coercive force.

Powder of barium ferrite or strontium ferrite can be synthesized by blending and mixing iron (Fe), barium chloride or strontium chloride (BaCl$_2$, SrCl$_2$), and as needed a metal oxide containing Ba or Sr as raw materials, followed by granulation and firing. Then, the fired body is pulverized to produce powder having a predetermined particle size. In one example, the firing conditions are: a temperature of 1200°C to 1300°C; a firing environment of atmosphere; and a firing time of about 1 to 8 hours.

The size of the powder to be produced can be adjusted by changing an application load in the pulverization. To obtain powder having a relatively large particle size, it is possible to adopt a method of subjecting the fired body to both of impact pulverization by a hammer mill and wet pulverization by an attritor, a planetary ball mill, or the like. The particle size can be adjusted by the impact pulverization by a hammer mill alone. The preferable particle size of the powder of barium ferrite or strontium ferrite is 1 $\mu$m to 5 $\mu$m in a median size (D50).

[Electromagnetic-wave absorbing layer]

Various kinds of rubber materials can be used as the rubber binder 1b constituting the electromagnetic-wave absorbing layer 1. Examples of the rubber materials include natural rubber (NR), isoprene rubber (IR), butadiene rubber (BR), styrene-butadiene rubber (SBR), butyl rubber (IIR), nitrile rubber (NBR), ethylene-propylene rubber (EPDM), chloroprene rubber (CR), acrylic rubber (ACM), chlorosulfonated polyethylene rubber (CSR), urethane rubber (PUR), silicone rubber (Q), fluororubber (FKM), ethylene-vinyl acetate rubber (EVA), epichlorohydrin rubber (CO), and polysulfide rubber (T).

Among these rubber materials, acrylic rubber and silicone rubber are preferred in terms of heat resistance. The acrylic rubber offers excellent oil resistance even in high temperature environments while being inexpensive and cost-effective. The silicone rubber offers not only high heat resistance but also high cold resistance. Moreover, the physical properties of the silicone rubber are most independent of temperature among synthetic rubbers, and the silicone rubber offers excellent solvent resistance, ozone resistance, and weather resistance. Further, the silicone rubber has excellent electrical insulation properties while being physically stable in a wide temperature range and a wide frequency region.

In the electromagnetic-wave absorbing layer 1 of the electromagnetic-wave absorbing sheet of this embodiment, when epsilon iron oxide powder is used as the electromagnetic-wave absorbing material 1a for example, it is important to favorably disperse the epsilon iron oxide powder in the binder 1b during the formation of the electromagnetic-wave absorbing layer 1, because the epsilon iron oxide powder is a fine nanoparticle having a particle size of several nm to several tens of nm as described above. For favorable dispersion, the electromagnetic-wave absorbing layer 1 of the electromagnetic-wave absorbing sheet of this embodiment contains a phosphate compound. Examples of the phosphate compound include: allyl sulfonic acids such as phenylphosphonic acid and phenylphosphonic dichloride; alkylphosphonic acids such as methylphosphonic acid, ethylphosphonic acid, octylphosphonic acid, propylphosphonic acid; and polyfunctional phosphonic acids such as hydroxyethanediphosphonic acid, nitrotris methylene phosphonic acid. These phosphate compounds are flame-retardant and function as dispersants for fine magnetic iron oxide powder, thereby favorably dispersing epsilon iron oxide particles in the binder.

More specifically, the dispersant may be phenylphosphonic acid (PPA) manufactured by FUJIFILM Wako Pure Chemical Corporation or Nissan Chemical Corporation, or an oxidized phosphoric acid ester "JP-502" (trade name) manufactured by JOHOKU CHEMICAL CO., LTD.

Adding the phosphate compound to a thermosetting addition type silicone rubber sometimes results in vulcanization inhibition. In that case, the dispersant is preferably a polymer dispersant other than the phosphate compound, silane, or a silane coupling agent. For example, decyltrimethoxysilane "KBM-3103" (trade name: manufactured by Shin-Etsu Chemical Co., Ltd.) can be suitably used as the dispersant.

In one example, the composition of the electromagnetic-wave absorbing layer 1 may be 2 to 50 parts of the rubber binder and 0.1 to 15 parts of the phosphate compound based on 100 parts of epsilon iron oxide powder (magnetic iron oxide). If the content of the rubber binder is less than 2 parts, the magnetic iron oxide cannot be favorably dispersed, and the shape of the electromagnetic-wave absorbing sheet cannot be maintained while the elongation of the electromagnetic-wave absorbing sheet is difficult to be obtained. If the content of the rubber binder exceeds 50 parts, the elongation of the electromagnetic-wave absorbing sheet can be obtained, but the volume content of the magnetic iron oxide in the electromagnetic-wave absorbing sheet is lowered and the permeability decreases, which lessens the electromagnetic-wave absorption effect.

If the content of the phosphate compound is less than 0.1 parts, the magnetic iron oxide cannot be favorably dispersed in the rubber binder. If the content of the phosphate compound exceeds 15 parts, the effect of favorably dispersing the magnetic iron oxide becomes saturated, and the volume content of the magnetic iron oxide in the electromagnetic-wave absorbing sheet is lowered and the permeability decreases, which lessens the electromagnetic-wave absorption effect.

[Method for producing electromagnetic-wave absorbing layer]

Hereinafter, a method for producing the electromagnetic-wave absorbing layer 1 of the electromagnetic-wave absorbing sheet of this embodiment will be described. The electromagnetic-wave absorbing layer 1 of the electromagnetic-wave absorbing sheet of this embodiment is formed by preparing a magnetic coating material that contains at least magnetic iron oxide powder and a rubber binder, and applying the magnetic coating material in a predetermined thickness, followed by drying and calendering. Although not essential, calendering is preferably performed to reduce voids in the electromagnetic-wave absorbing sheet so as to improve the filling degree of the magnetic iron oxide power.

First, the magnetic coating material is prepared.

The magnetic coating material is prepared by obtaining a kneaded mixture of epsilon iron oxide powder (magnetic iron oxide), a phosphate compound (dispersant) and a rubber binder, and diluting the kneaded mixture with a solvent, followed by dispersion and filtration with a filter. In one example, the kneaded mixture can be obtained by mixing and kneading the materials with a pressurized batch-type kneader. In one example, the dispersion of the kneaded mixture can be obtained as a dispersion liquid using a sand mill filled with beads (e.g., zirconia). At this time, a crosslinking agent may be blended as needed.

The magnetic coating material thus obtained is applied to a peelable support using a table coater, a bar coater, or the like. In one example, the peelable support is a 38 $\mu$m-thick polyethylene terephthalate (PET) sheet that has been subjected to a peeling treatment by silicone coating.

The magnetic coating material in a wet state is dried at 80°C and calendered with a predetermined temperature and pressure using a calender to form an electromagnetic-wave absorbing layer on the support.

In one example, by applying the magnetic coating material in a thickness of 1 mm in a wet state on the support, it is possible to obtain an electromagnetic-wave absorbing layer having a thickness of 400 $\mu$m after drying and a thickness of 300 $\mu$m after calendering.

Thus, the electromagnetic-wave absorbing layer 1 in which nano-order fine epsilon iron oxide powder (electromagnetic-wave absorbing material 1a) is favorably dispersed in the rubber binder 1b can be formed.

Another method for preparing the magnetic coating material may a method including mixing, as the magnetic coating material components, at least magnetic iron oxide powder, a phosphate compound (dispersant) and a rubber binder at high speed with a high-speed stirrer to prepare a mixture, and dispersing the mixture with a sand mill.

[Adhesive layer]

In the electromagnetic-wave absorbing sheet of this embodiment, the adhesive layer 2 is formed on the back surface of the electromagnetic-wave absorbing layer 1 as illustrated in FIG. 1.

By providing the adhesive layer 2, the electromagnetic-wave absorbing layer 1 can be attached to a desired position such as an inner surface of a housing that contains an electric circuit, or an inner surface or outer surface of an electric device. Specifically, since the electromagnetic-wave absorbing layer 1 of the electromagnetic-wave absorbing sheet of this embodiment has elasticity, it can be attached easily even on a curved surface (bent surface) using the adhesive layer 2. Thus, the adhesive layer 2 improves the handleability of the electromagnetic-wave absorbing sheet. To avoid a situation that the adhesive layer 2 impairs the elongation by elastic deformation of the electromagnetic-wave absorbing layer 1, the materials, formation thickness and formation state of the adhesive layer 2 are appropriately selected. Preferable examples of the materials include acrylic, silicone, and rubber adhesives having a low glass-transition temperature (Tg).

The adhesive layer 2 may be formed of a known material generally used as an adhesive layer such as an adhesive tape, and examples of which include an acrylic adhesive, a rubber adhesive, or a silicone adhesive. Particularly when the rubber binder is silicone rubber, it is preferred that the material of the adhesive layer is a silicone adhesive so as not to lower the adhesion between the electromagnetic-wave absorbing layer and the adhesive layer.

A tackifier or crosslinking agent may be used to adjust the tackiness with respect to an adherend or reduce adhesive residues. The tackiness with respect to an adherend is preferably 5 N/10 mm to 12 N/10 mm. If the tackiness is smaller than 5 N/10 mm, the electromagnetic-wave absorbing sheet may be easily peeled off or displaced from an adherend. If the tackiness is larger than 12 N/10 mm, the electromagnetic-wave absorbing sheet is difficult to be peeled off from an adherend.

The thickness of the adhesive layer 2 is preferably 20 $\mu$m to 100 $\mu$m. If the adhesive layer is thinner than 20 pm, the tackiness is low and the electromagnetic-wave absorbing sheet may be easily peeled off or displaced from an adherend. If the adhesive layer is thicker than 100 pm, the electromagnetic-wave absorbing sheet as a whole becomes thick, which may deteriorate the flexibility of the sheet. Further, if the adhesive layer 2 is thick, the electromagnetic-wave absorbing sheet is difficult to be peeled off from an adherend. If cohesion of the adhesive layer 2 is low, an adhesive may remain on an adherend when the electromagnetic-wave absorbing sheet is peeled off from the adherend.

The adhesive layer 2 in the present specification may be an adhesive layer 2 for unpeelable attachment, or an adhesive layer 2 for peelable attachment.

In the attachment of the electromagnetic-wave absorbing sheet to a predetermined surface, an electromagnetic-wave absorbing sheet that is not provided with the adhesive layer 2 and that is formed only of the electromagnetic-wave absorbing layer 1 also can be attached to a predetermined site by imparting tackiness to the surface of a member on which the electromagnetic-wave absorbing sheet is to be arranged. A double-sided tape or an adhesive may be used to attach the electromagnetic-wave absorbing sheet to a predetermined site. In this respect, the adhesive layer 2 is not an essential component in the electromagnetic-wave absorbing sheet of this embodiment. However, the configuration of the electromagnetic-wave absorbing sheet including the adhesive layer 2 is preferred because it can be attached to a predetermined site without using a double-sided tape or an adhesive.

[Elongation of electromagnetic-wave absorbing sheet]

The following describes the elongation in the in-plane direction of the electromagnetic-wave absorbing sheet of this embodiment.

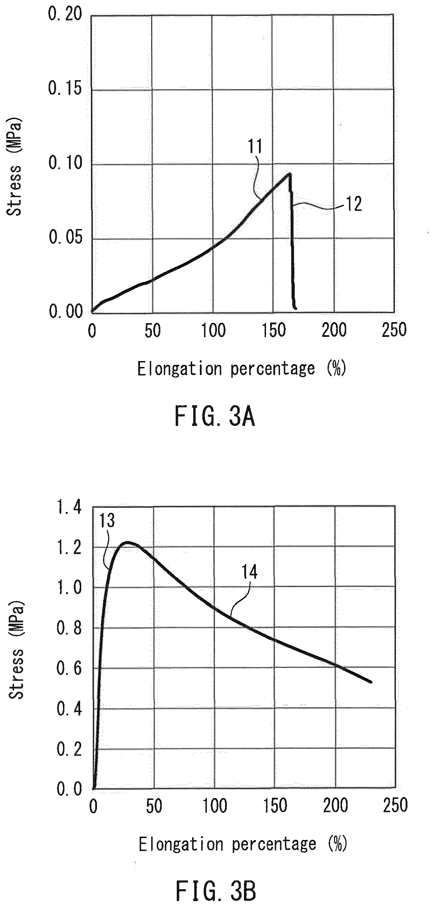

FIG. 3 is a graph illustrating a relationship between a stress (tensile stress) applied in the in-plane direction in the electromagnetic-wave absorbing sheet of this embodiment and an elongation percentage of the electromagnetic-wave absorbing sheet. FIG. 3A illustrates a relationship between the stress and the elongation percentage in the electromagnetic-wave absorbing sheet that ruptures when exceeding the maximum elongation percentage. FIG. 3B illustrates a relationship between the stress and the elongation percentage in the electromagnetic-wave absorbing sheet that causes plastic deformation when exceeding the maximum elongation percentage.

Here, "elongation percentage" is a value expressed in percentage (%), which is obtained by dividing the elongation amount of the electromagnetic-wave absorbing sheet that is elongated by a stress applied thereto in one direction, by the original length of the sheet. More specifically, the "elongation percentage" of the electromagnetic-wave absorbing sheet when a predetermined stress is applied thereto can be expressed by $(L2-L1)/L1 \times 100$, where L1 represents the length of the sheet when the stress is 0, and L2 represents the length of the sheet when a predetermined stress is applied. The "elongation percentage" is also called "strain".

As illustrated in FIG. 3A, in the electromagnetic-wave absorbing sheet that ruptures when exceeding the maximum elongation percentage, the elongation percentage of the electromagnetic-wave absorbing sheet increases substantially linearly as the stress applied externally increases (section denoted by reference numeral 11) until the sheet reaches the maximum elongation percentage of 170%. If the stress is applied beyond the maximum elongation percentage of 170%, the electromagnetic-wave absorbing sheet ruptures, and the elongation percentage no longer increases from the maximum elongation percentage of 170% (section denoted by reference numeral 12).

Meanwhile, as illustrated in FIG. 3B, in the electromagnetic-wave absorbing sheet that causes plastic deformation when exceeding the maximum elongation percentage, the elongation percentage increases relatively moderately as the stress increases (section denoted by reference numeral 13) until the sheet reaches the elongation percentage of 30%, which is an elongation percentage indicating the maximum stress. If the electromagnetic-wave absorbing sheet is stretched further after reaching the elongation percentage of 30% indicating the maximum stress, the sheet plastically deforms and is stretched out until the sheet reaches the elongation percentage of 230% (section denoted by reference numeral 14). Because of this, the stress decreases gradually. The plastically deformed electromagnetic-wave absorbing sheet in the state denoted by reference numeral 14 has lost its elasticity, and cannot be returned to its original length even when the force of stretching the electromagnetic-wave absorbing sheet is released.

The elastic deformation region of the rubber material to be used as the binder 1b can be adjusted by using an appropriately selected vulcanizing agent. If the electromagnetic-wave absorbing sheet is required not rupture in relation to the intended use, it is effective to configure the sheet to cause plastic deformation instead of rupture.

The upper limit of the elongation of the electromagnetic-wave absorbing sheet is set to 200% to avoid a situation that the input impedance of the electromagnetic-wave absorbing sheet too largely differs from the impedance in the air to match the impedances, and the electromagnetic-wave absorbing ability decreases. If the elongation of the electromagnetic-wave absorbing sheet is too large, the electromagnetic-wave absorbing sheet becomes thin, and the density of the electromagnetic-wave absorbing material decreases, which decreases the electromagnetic-wave absorbing ability. In a state where the elongation of the electromagnetic-wave absorbing sheet exceeds 200%, the flexibility and bendability of the electromagnetic-wave absorbing sheet decrease.

Meanwhile, if the elongation of the electromagnetic-wave absorbing sheet is less than 20%, the sheet cannot be sufficiently stretched in the attachment to a curved adherend, and workability decreases. Moreover, such an electromagnetic-wave absorbing sheet having an elongation of less than 20% cannot be attached to a movable part that changes its shape, and one of characteristics of the electromagnetic-wave absorbing sheet of this embodiment - elasticity - cannot be exhibited.

Here, the relationship between the external tensile stress and the elongation percentage of the electromagnetic-wave absorbing sheet of this embodiment was measured by actually producing electromagnetic-wave absorbing sheets using various kinds of magnetic iron oxides and rubber binders.

A first electromagnetic-wave absorbing sheet (Example 1) was produced using epsilon iron oxide as the magnetic iron oxide and acrylic rubber as the rubber binder.

Table 1 indicates the materials used for the production of the first electromagnetic-wave absorbing sheet and the proportions of the materials.

[Table 1]

| Material | Part | Trade name | Manufacturer |
|---|---|---|---|
| Epsilon iron oxide (average particle size 30 nm) substituted with gallium ($\varepsilon$-$Ga_{0.47}Fe_{1.53}O_3$) | 100 | - | - |
| Acrylic rubber | 33 | Nipol AR51 | ZEON CORPORATION |
| Phenylphosphonic acid | 3 | PPA | Nissan Chemical Corporation |
| Methyl ethyl ketone | 180 | - | - |
| Stearic acid (vulcanizing accelerator aid) | 0.2 | LUNAC S-98 | Kao Corporation |
| Ammonium benzoate (vulcanizing agent) | 0.5 | Vulnoc AB-S | OUCHI SHINKO CHEMICAL CO., LTD. |

A second electromagnetic-wave absorbing sheet (Example 2) was produced using epsilon iron oxide as the magnetic iron oxide similarly to the first electromagnetic-wave absorbing sheet and silicone rubber as the rubber binder. Table 2 indicates the materials used for the production of the second electromagnetic-wave absorbing sheet and the proportions of the materials.

[Table 2]

| Material | Part | Trade name | Manufacturer |
|---|---|---|---|
| Epsilon iron oxide (average particle size 30 nm) substituted with gallium ($\varepsilon$-$Ga_{0.47}Fe_{1.53}O_3$) | 100 | - | - |
| Decyltrimethoxysilane | 2 | KBM-3103 | Shin-Etsu Chemical Co., Ltd. |
| Silicone rubber | 30 | KE-541-U | Shin-Etsu Chemical Co., Ltd. |
| 2.5 dimethyl-2.5 bis (tertiarybutylperoxy) hexane | 0.8 | C-8A | Shin-Etsu Chemical Co., Ltd. |

A third electromagnetic-wave absorbing sheet (Example 3) was produced using strontium ferrite as the magnetic iron oxide and silicone rubber as the rubber binder similarly to the second electromagnetic-wave absorbing sheet. Table 3 indicates the materials used for the production of the third electromagnetic-wave absorbing sheet and the proportions of the materials.

[Table 3]

| Material | Part | Trade name | Manufacturer |
|---|---|---|---|
| Strontium ferrite (magnetoplumbite type ferrite) $SrFe_{(12-X)}AL_XO_{19}$ Part of Fe of strontium ferrite is substituted with Al | 100 | - | - |
| Silicone rubber | 30 | KE-510-U | Shin-Etsu Chemical Co., Ltd. |
| 2.5 dimethyl-2.5 bis (tertiarybutylperoxy) hexane | 0.8 | C-8A | Shin-Etsu Chemical Co., Ltd. |

The materials of the first, second, and third electromagnetic-wave absorbing sheets in the proportions indicated in Tables 1-3 were each mixed and kneaded with a pressurized batch-type kneader. The obtained kneaded mixtures were diluted with 170 parts of methyl ethyl ketone, and dispersed using a sand mill filled with zirconia beads to prepare respective dispersion liquids.

The dispersion liquid indicated in Table 1 was applied using a sheet-type coater onto a 38 um-thick polyethylene terephthalate (PET) sheet that had been subjected to a peeling treatment by silicone coating.

Each of the dispersion liquids indicated in Tables 2 and 3 was applied using a sheet-type coater onto a 38 um-thick polyethylene terephthalate (PET) sheet that had been subjected to a peeling treatment with a non-silicone remover.

Each of the coating materials in a wet state was dried at 80°C and calendered in a thickness of 500 $\mu$m to form an electromagnetic-wave absorbing layer.

Five electromagnetic-wave absorbing layers thus formed each having a thickness of 500 $\mu$m were thermally compressed by a calender to form a single electromagnetic-wave absorbing layer having a thickness of 2500 $\mu$m. Each of the electromagnetic-wave absorbing sheets was not provided with an adhesive layer and composed only of the electromagnetic-wave absorbing layer.

Each of the electromagnetic-wave absorbing sheets was measured for the elongation percentage using a tensile tester. Specifically, the elongation percentage of the sheet (20 mm × 50 mm) when stretched at a stretching rate of 10 mm/min was measured using a TGE-1kN tester (trade name) manufactured by MinebeaMitsumi Inc., and TT3E-200N as a load cell. The elongation percentage measurement was performed at a temperature of 23°C and a humidity of 50%Rh.

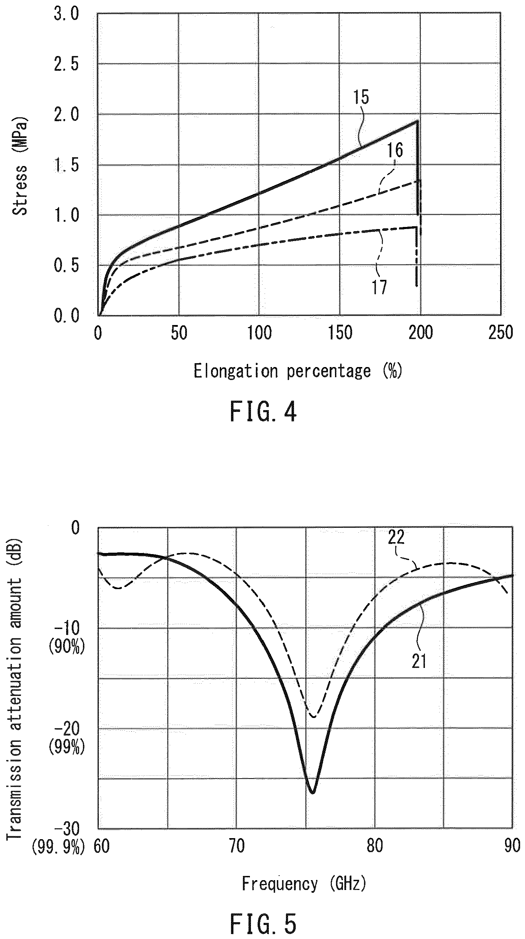

FIG. 4 illustrates the elongation percentages of the three electromagnetic-wave absorbing sheets measured in the above-described manner.

In FIG. 4, the elongation percentage of the first electromagnetic-wave absorbing sheet is indicated by a solid line (reference numeral 15), the elongation percentage of the second electromagnetic-wave absorbing sheet is indicated by a dotted line (reference numeral 16), and the elongation percentage of the third electromagnetic-wave absorbing sheet is indicated by a dashed-two dotted line (reference numeral 17).

As indicated in FIG. 4, all of the three electromagnetic-wave absorbing sheets produced as examples were electromagnetic-wave absorbing sheets that rupture when exceeding the maximum elongation percentage as illustrated in FIG. 3A, and had the maximum elongation percentage in a range from 195% to 200%. As described above, a preferable maximum elongation in the electromagnetic-wave absorbing sheet of this embodiment is 200%. The three electromagnetic-wave absorbing sheets produced were within a preferable range in electromagnetic-wave absorbing properties, flexibility, and bendability.

Among the three electromagnetic-wave absorbing sheets, the first electromagnetic-wave absorbing sheet 15 required the largest stress to have the same elongation percentage, and the third electromagnetic-wave absorbing sheet 17 required the least stress to have the same elongation percentage. The reasons for this are considered as follows. The acrylic rubber used had higher hardness than the silicone rubbers used, and the silicone rubber used in the second electromagnetic-wave absorbing sheet had higher hardness than the silicone rubber used in the third electromagnetic-wave absorbing sheet. Moreover, since the strontium ferrite (magnetic iron oxide) used in the third electromagnetic-wave absorbing sheet had a larger particle size than the epsilon iron oxide (magnetic iron oxide) used in the first electromagnetic-wave absorbing sheet, the specific surface area was small and the dispersibility increased, and thereby the hardness of the third electromagnetic-wave absorbing sheet was lowered.

Next, the electromagnetic-wave absorbing sheet of this embodiment was measured for the change in the electromagnetic-wave absorbing properties when being stretched by application of stress.

The electromagnetic-wave absorption amount (electromagnetic-wave attenuation amount) of the first electromagnetic-wave absorbing sheet was measured in accordance with a free space method. Specifically, a millimeter-wave network analyzer ME7838AN5250C (trade name) manufactured by ANRITSU CORPORATION was used to irradiate the electromagnetic-wave absorbing sheet with input waves (millimeter-waves) having a predetermined frequency from a transmission antenna via a dielectric lens and measure electromagnetic waves passing through the sheet by a reception antenna disposed on the back side of the sheet. The intensity of the irradiated electromagnetic waves and the intensity of the transmitted electromagnetic waves were measured as voltages, and the electromagnetic-wave attenuation amount was determined in dB from the intensity difference.

FIG. 5 illustrates the electromagnetic-wave absorbing properties of the first electromagnetic-wave absorbing sheet of this embodiment in a state where no tension was applied thereto, and the electromagnetic-wave absorbing properties of the first electromagnetic-wave absorbing sheet in a state where the sheet was stretched and the thickness decreased by application of tension.

In FIG. 5, a solid line denoted by reference numeral 21 indicates the electromagnetic-wave absorbing properties of the electromagnetic-wave absorbing sheet in a state where no tension was applied thereto, i.e., the elongation percentage was 0%. The thickness of the electromagnetic-wave absorbing sheet at this time was 2500 $\mu$m as produced.

As illustrated in FIG. 5, the first electromagnetic-wave absorbing sheet exhibited high electromagnetic-wave absorbing properties of the electromagnetic-wave absorption amount (the attenuation amount of electromagnetic waves transmitted to the back surface side of the sheet from incident electromagnetic waves) of 26 dB at 75.5 GHz, which is the resonance frequency of epsilon iron oxide as the electromagnetic-wave absorbing material.

A dotted line denoted by reference numeral 22 in FIG. 5 indicates the electromagnetic-wave absorbing properties of the electromagnetic-wave absorbing sheet when stretched to have an elongation percentage of 75% by application of tension. The thickness of the electromagnetic-wave absorbing sheet at this time was 1950 $\mu$m.

As indicated by the dotted line as reference numeral 22 in FIG. 5, the electromagnetic-wave absorption amount of the electromagnetic-wave absorbing sheet in the state of the elongation percentage of 75% was about 19 dB at 75.5 GHz, and this indicates that the electromagnetic-wave absorbing properties decreased as compared with the case of the elongation percentage of 0% (reference numeral 21). The reason for this is considered to be that the stretching of the electromagnetic-wave absorbing sheet in the in-plane direction decreased the thickness of the sheet, and the content of the electromagnetic-wave absorbing material in the transmitting direction of electromagnetic waves in the electromagnetic-wave absorbing sheet was virtually lowered.

That is, it was found that the transmission-type electromagnetic-wave absorbing sheet such as the first electromagnetic-wave absorbing sheet decreases its electromagnetic-wave absorbing properties by being stretched in the in-plane direction.

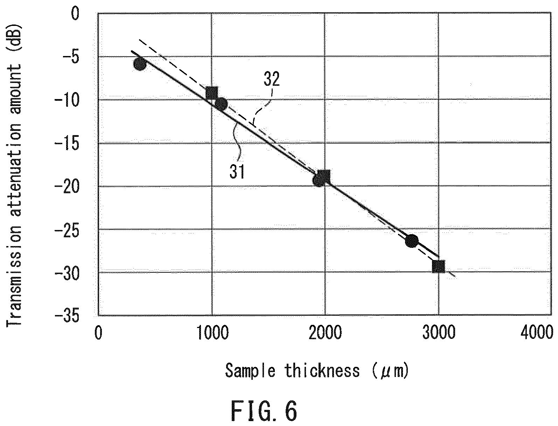

To study this in more detail, the present inventors measured the electromagnetic-wave absorbing properties by further increasing the elongation percentage of the electromagnetic-wave absorbing sheet to measure a relationship between the thickness and the electromagnetic-wave absorption amount in the electromagnetic-wave absorbing sheet whose thickness decreased by stretching in the in-plane direction. FIG. 6 shows the results.

FIG. 6 illustrates the relationship between the thickness of the first and third electromagnetic-wave absorbing sheets when stretched in one in-plane direction and the electromagnetic-wave absorption amount (the attenuation amount of transmitted electromagnetic waves: transmission attenuation amount) at a frequency of 75.5 GHz in that state.

In FIG. 6, black circles and a solid line 31 indicate a change in the electromagnetic-wave absorption amount of the first electromagnetic-wave absorbing sheet, and black squares and a dotted line 32 indicate a change in the electromagnetic-wave absorption amount of the third electromagnetic-wave absorbing sheet.

FIG. 6 indicates that, in both of the first and third electromagnetic-wave absorbing sheets, the electromagnetic-wave absorption amounts (31, 32) at a frequency of 75.5 GHz changed almost in proportion to the thicknesses of the sheets, and the electromagnetic-wave absorbing properties decreased as the thicknesses decreased by stretching.

Thus, the electromagnetic-wave absorbing sheet of this embodiment linearly decreases its electromagnetic-wave absorbing properties corresponding to the elongation percentage when elongated by application of tension. In view of the above, the electromagnetic-wave absorbing sheet can be used in the stretched state within a range that can provide a desired electromagnetic-wave absorption amount and within the maximum elongation percentage of the sheet and the elastic region.

(Embodiment 2)

[Reflection-type electromagnetic-wave absorbing sheet according to claim 9]

Next, a reflection-type electromagnetic-wave absorbing sheet in which a reflective layer is formed on the back surface of an electromagnetic-wave absorbing layer, which is a second configuration example of the electromagnetic-wave absorbing sheet of the present application, will be described with reference to a specific embodiment.

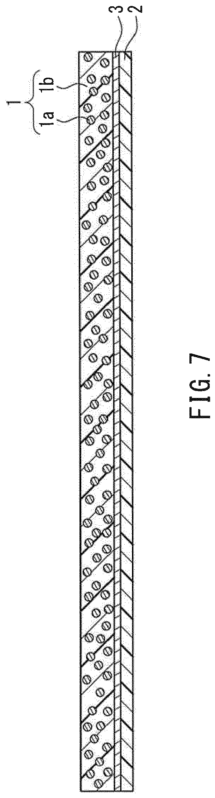

FIG. 7 illustrates the cross-sectional configuration of the electromagnetic-wave absorbing sheet of Embodiment 2.

Similarly to FIG. 1 illustrating the configuration of the electromagnetic-wave absorbing sheet of Embodiment 1, FIG. 7 is illustrated for the sake of easy understanding of the configuration, and does not faithfully reflect the actual sizes or thicknesses of members illustrated therein. The same components as those constituting the electromagnetic-wave absorbing sheet of Embodiment 1 illustrated in FIG. 1 are denoted with the same reference numerals, and the detailed descriptions thereof will be omitted.

The electromagnetic-wave absorbing sheet disclosed in the present application absorbs electromagnetic waves by the magnetic resonance of a magnetic iron oxide (e.g., epsilon iron oxide, barium ferrite, strontium ferrite) that constitutes an electromagnetic-wave absorbing layer as the electromagnetic-wave absorbing material together with a rubber binder. The electromagnetic-wave absorbing sheet of the present application can be configured not only as the transmission-type electromagnetic-wave absorbing sheet not provided with a reflective layer exemplified in Embodiment 1, but also as a reflection-type electromagnetic-wave absorbing sheet that includes a reflective layer for reflecting electromagnetic waves on a surface of the electromagnetic-wave absorbing layer on a side opposite to the electromagnetic-wave incident side.

In the electromagnetic-wave absorbing sheet of Embodiment 2, a reflective layer 3 is formed in contact with a back surface (lower surface in FIG. 7) of an electromagnetic-wave absorbing layer 1 that contains a magnetic iron oxide 1a as the electromagnetic-wave absorbing material and a rubber binder 1b.

In the electromagnetic-wave absorbing sheet of Embodiment 2 illustrated in FIG. 7, an adhesive layer 2 is formed on the back surface side of the reflective layer 3 to make the electromagnetic-wave absorbing sheet attachable to a predetermined position. Similarly to the electromagnetic-wave absorbing sheet of Embodiment 1, the adhesive layer 2 is not an essential component in the electromagnetic-wave absorbing sheet of Embodiment 2, and the electromagnetic-wave absorbing sheet can be formed without the adhesive layer 2. However, the configuration of the electromagnetic-wave absorbing sheet including the adhesive layer 2 is preferred because it can be attached to a predetermined site without using a double-sided tape or an adhesive.

Any metal layer that is formed in contact with the back surface of the electromagnetic-wave absorbing layer 1 can be used as the reflective layer 3. However, since the electromagnetic-wave absorbing sheet of this embodiment has elasticity using the rubber binder 1b, the reflective layer 3 is preferably a mesh conductor, a silver nanowire (Ag-NW), a conductive polymeric film, or the like so that even when the electromagnetic-wave absorbing layer 1 is stretched, the surface resistance does not greatly increase and the resistance of about 1 $\Omega/\square$ can be maintained.

The method for forming the reflective layer on the back surface of the electromagnetic-wave absorbing layer 1 may be a method including spraying or applying silver nanowires or a conductive polymer onto the back surface side of the electromagnetic-wave absorbing sheet. Further, the method may be a method including dispersing silver nanowires or a conductive polymer in a rubber binder to form a reflective layer 3 and attaching the elastic reflective layer 3 to the electromagnetic-wave absorbing layer by thermocompression bonding, or a method including applying a coating material for forming the electromagnetic-wave absorbing layer 1 on the elastic reflective layer 3 to form the electromagnetic-wave absorbing layer 1 on the reflective layer 3.

The type of the metal constituting the reflective layer 3 is not particularly limited, and may be a metal having a high corrosion resistance and a minimum electrical resistance, such as aluminum, copper, and chromium, in addition to the silver used as nanowires.

In the electromagnetic-wave absorbing sheet of Embodiment 2 illustrated in FIG. 7, the reflective layer 3 provided on the back surface of the electromagnetic-wave absorbing layer 1 can reliably avoid a situation that electromagnetic waves penetrate through the electromagnetic-wave absorbing sheet. Therefore, in particular, the electromagnetic-wave absorbing sheet of Embodiment 2 can be suitably used as an electromagnetic-wave absorbing sheet that prevents the leakage of electromagnetic waves to be emitted to the outside from electric circuit components driven at high frequencies.

[Elongation of reflection-type electromagnetic-wave absorbing sheet]

Similarly to the electromagnetic-wave absorbing sheet of Embodiment 1, the reflection-type electromagnetic-wave absorbing sheet of Embodiment 2 changes its electromagnetic-wave absorbing properties when the electromagnetic-wave absorbing layer 1 is elongated by stretching and changes its thickness. Such a thickness reduction changes the input impedance, causes impedance mismatch, and changes the electromagnetic-wave absorbing properties. Such a thickness reduction also lowers the amount of the electromagnetic-wave absorbing material in a portion of the electromagnetic-wave absorbing layer 1 where electromagnetic waves pass through, and changes the electromagnetic-wave absorbing properties.

Moreover, in the case of the reflection-type electromagnetic-wave absorbing sheet, it is necessary to match the input impedance of the electromagnetic-wave absorbing sheet to the impedance in the air. If the input impedance of the electromagnetic-wave absorbing sheet largely differs from the impedance in the air of 377 $\Omega$ (precisely, impedance in a vacuum), reflection or scattering occurs when electromagnetic waves enter the electromagnetic-wave absorbing sheet. This deteriorates the electromagnetic-wave absorbing properties of the reflection-type electromagnetic-wave absorbing sheet of reducing reflected waves of incident electromagnetic waves.

Here, an impedance $Z_{in}$ of the electromagnetic-wave absorbing layer 1 in the electromagnetic-wave absorbing sheet containing a magnetic iron oxide as the electromagnetic-wave absorbing material is expressed by Formula (1) below.

[Numerical Formula 1]

$$Z_{in} = Z_o \sqrt{\frac{\mu_r}{\varepsilon_r}} \tanh\left( \iota \frac{2\pi d}{\lambda} \sqrt{\varepsilon_r \mu_r} \right) \qquad (1)$$

In Formula (1) above, $\mu_r$ is a complex permeability of the electromagnetic-wave absorbing layer 1, $\varepsilon_r$ is a complex permittivity of the electromagnetic-wave absorbing layer 1, $\lambda$ is a wavelength of incident electromagnetic waves, and d is a thickness of the electromagnetic-wave absorbing layer 1. When the electromagnetic-wave absorbing sheet is stretched, the thickness d of the electromagnetic-wave absorbing layer 1 decreases, and the content of the magnetic iron oxide (electromagnetic-wave absorbing material) is lowered, whereby both the permeability and the permittivity of the electromagnetic-wave absorbing layer 1 change. Consequently, the input impedance (Zin) of the electromagnetic-wave absorbing sheet is affected by the thickness of the binder 1b forming the electromagnetic-wave absorbing layer 1. In other words, when the thickness of the electromagnetic-wave absorbing sheet fluctuates along with the extension and contraction of the sheet, the input impedance (Zin) of the sheet fluctuates.

On these bases, the present inventors arrived at an idea that, by matching the input impedance of the electromagnetic-wave absorbing sheet to the impedance in the air, not in the stationary state of the electromagnetic-wave absorbing sheet (i.e., any external force is applied to the sheet and the elongation percentage of the sheet is 0%), but in a state where the electromagnetic-wave absorbing sheet is elongated by a certain elongation percentage, it is possible to provide an electromagnetic-wave absorbing sheet that can more favorably absorb incident electromagnetic waves in a wider range of conditions in the practical use.

Therefore, the present inventors actually produced a reflection-type electromagnetic-wave absorbing sheet to verify an effect obtained by matching the input impedance of the electromagnetic-wave absorbing sheet to the impedance in the air in the state where the sheet is elongated by a certain elongation percentage.

First, a reflection-type electromagnetic-wave absorbing sheet was produced as a fourth electromagnetic-wave absorbing sheet (Example 4).

Similarly to the first electromagnetic-wave absorbing sheet described above, the materials of the reflection-type electromagnetic-wave absorbing sheet as the fourth electromagnetic-wave absorbing sheet in the proportion indicated in Table 1 were mixed and kneaded with a pressurized batch-type kneader. The obtained kneaded mixture was diluted with 170 parts of methyl ethyl ketone, and dispersed using a sand mill filled with zirconia beads to prepare a dispersion liquid.

The dispersion liquid was applied using a sheet-type coater onto a 38 um-thick polyethylene terephthalate (PET) sheet that had been subjected to a peeling treatment by silicone coating.

The coating material in a wet state was dried at 80°C and calendered in a thickness of 410 $\mu$m to form an electromagnetic-wave absorbing layer.

Next, a reflective layer was formed on the back surface of the electromagnetic-wave absorbing layer.

Specifically, the reflective layer was formed by applying silver nanowires to the back surface side of the electromagnetic-wave absorbing layer.

Similarly to the electromagnetic-wave absorption measurement of the transmission-type electromagnetic-wave absorbing sheet, the free space method was adopted to measure the electromagnetic-wave absorbing properties of the fourth electromagnetic-wave absorbing sheet. In the measurement of the properties of the reflection-type electromagnetic-wave absorbing sheet, the transmission antenna and the reception antenna were disposed on the front surface side of the electromagnetic-wave absorbing sheet to measure the output of electromagnetic waves entering the electromagnetic-wave absorbing sheet and the output of reflected waves emitted from the electromagnetic-wave absorbing sheet.

Incidentally, the electromagnetic-wave absorbing sheet including the electromagnetic-wave absorbing layer composed mainly of acrylic rubber as the binder, which was produced as the fourth electromagnetic-wave absorbing sheet, was an electromagnetic-wave absorbing sheet that causes plastic deformation when exceeding a predetermined maximum elongation percentage (specifically, the maximum elongation percentage of the fourth electromagnetic-wave absorbing sheet was 30%) as indicated in FIG. 3B.

The fourth electromagnetic-wave absorbing sheet had a thickness of 370 $\mu$m at the elongation percentage of 11%. The input impedance of the electromagnetic-wave absorbing sheet in the state of having a thickness of 370 $\mu$m became 377 $\Omega$, which matches the impedance in the air.

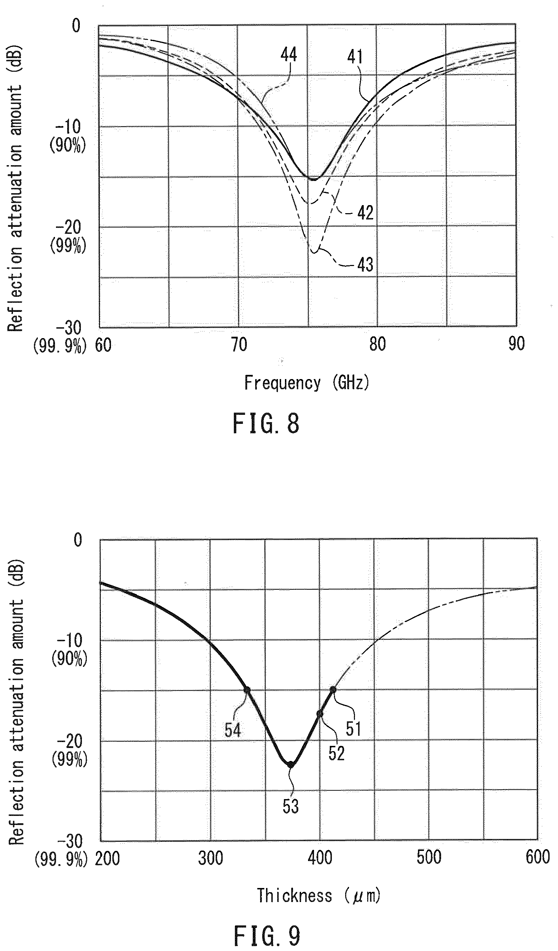

FIG. 8 illustrates a change in the electromagnetic-wave absorbing properties according to a change in the elongation percentage in the fourth electromagnetic-wave absorbing sheet.

In FIG. 8, a solid line denoted by reference numeral 41 indicates the electromagnetic-wave absorption amount (attenuation amount of reflected electromagnetic waves) in the stationary state of the fourth electromagnetic-wave absorbing sheet, i.e., in the state of the elongation percentage of 0%. The thickness of the fourth electromagnetic-wave absorbing sheet at this time was 410 $\mu$m. A dotted line denoted by reference numeral 42 indicates a state where the fourth electromagnetic-wave absorbing sheet was stretched by the elongation percentage of 3%, and the thickness of the electromagnetic-wave absorbing sheet at this time was 400 $\mu$m. A dashed-dotted line denoted by reference numeral 43 indicates a state where the fourth electromagnetic-wave absorbing sheet was stretched by the elongation percentage of 11%, and the thickness of the electromagnetic-wave absorbing sheet at this time was 370 $\mu$m. A dashed-two dotted line denoted by reference numeral 44 indicates a state where the fourth electromagnetic-wave absorbing sheet was stretched by the elongation percentage of 22%, and the thickness of the electromagnetic-wave absorbing sheet at this time was 335 $\mu$m.

As illustrated in FIG. 8, the fourth electromagnetic-wave absorbing sheet in a state of being elongated by the elongation percentage of 11%, i.e., the input impedance matched the impedance in the air, resulted in the largest electromagnetic-wave absorption amount of about 23 dB. Meanwhile, the electromagnetic-wave absorption amount at the elongation percentage of 3% was about 18 dB, and the electromagnetic-wave absorption amount at the elongation percentage of 0% was about 15 dB. These results differ from the results of FIGS. 5 and 6, which illustrate the electromagnetic-wave absorbing properties of the first electromagnetic-wave absorbing sheet and indicate that the electromagnetic-wave absorption amount decreased by the elongation of the electromagnetic-wave absorbing sheet. In other words, in Embodiment 2, the electromagnetic-wave absorption amount increased as the elongation percentage increased, which is converse to the results of Embodiment 1.

The above indicates that the decrease in the electromagnetic-wave absorption amount in the reflection-type electromagnetic-wave absorbing sheet is more strongly affected by impedance mismatch, which is caused by the change in the input impedance according to the change in the thickness of the electromagnetic-wave absorbing layer, than the lowered amount of the electromagnetic-wave absorbing material in the portion of the electromagnetic-wave absorbing layer where electromagnetic waves pass through, by elongation of the electromagnetic-wave absorbing sheet.

Therefore, in the reflection-type electromagnetic-wave absorbing sheet, it is preferable to match the input impedance of the electromagnetic-wave absorbing sheet to the impedance in the air in consideration of the change in the input impedance of the electromagnetic-wave absorbing layer according to the change in the elongation percentage of the electromagnetic-wave absorbing sheet.

FIG. 9 is a graph illustrating a relationship between the thickness and the electromagnetic-wave absorption amount of the fourth electromagnetic-wave absorbing sheet and expressing, in a different manner, the change in the electromagnetic-wave absorbing properties in the fourth electromagnetic-wave absorbing sheet illustrated in FIG. 8.

In FIG. 9, reference numeral 51 indicates the electromagnetic-wave absorption amount in the state of the elongation percentage of 0% (thickness 410 μm), reference numeral 52 indicates the electromagnetic-wave absorption amount in the state of the elongation percentage of 3% (thickness 400 μm), reference numeral 53 indicates the electromagnetic-wave absorption amount in the state of the elongation percentage of 11% (thickness 370 μm), and reference numeral 54 indicates the electromagnetic-wave absorption amount in the state of the elongation percentage of 22% (thickness 335 μm).

As illustrated in FIG. 9, by matching the input impedance of the fourth electromagnetic-wave absorbing sheet in the state where the sheet is stretched by the elongation percentage of 11% and the thickness becomes 370 pm, the sheet can maintain an electromagnetic-wave absorption amount of 15 dB or less, i.e., an electromagnetic-wave absorption amount of 92% or more, which is considered to be practically preferable, between the state of the elongation percentage of 0% and the state of the elongation percentage of 22%.

As described above, the electromagnetic-wave absorbing sheet of this embodiment is a stretchable electromagnetic-wave absorbing sheet having the maximum elongation percentage of the elastic region of 20% to 200%, and can maintain its electromagnetic-wave absorption amount even when used in the stretched state within this range. Moreover, the electromagnetic-wave absorbing sheet of this embodiment is an electromagnetic-wave absorbing sheet that can maintain a predetermined electromagnetic-wave absorption amount as long as the sheet has the maximum elongation percentage of the elastic region of 20% to 200%, and is stretched by 5% to 75% of the maximum elongation percentage of the elastic region.

As is clear from the above description, in the electromagnetic-wave absorbing sheet containing, as the electromagnetic-wave absorbing material, a magnetic member that absorbs electromagnetic waves by the magnetic resonance and changes the thickness by its elasticity, it is preferable to match the input impedance of the electromagnetic-wave absorbing layer to the impedance in the air in the state where the sheet is stretched to a certain extent.

The above is not limited to the electromagnetic-wave absorbing sheet described in Embodiment 2 in which the electromagnetic-wave absorbing material magnetically resonates with electromagnetic waves in a high frequency band equal to or higher than the millimeter-wave band. In all the elastic reflection-type electromagnetic-wave absorbing sheets that absorb electromagnetic waves by the magnetic resonance of the electromagnetic-wave absorbing material dispersed in the rubber binder, it is preferable to match the input impedance of the electromagnetic-wave absorbing layer to the impedance in the air in the state where the sheet is stretched to a certain extent.

As to the fourth electromagnetic-wave absorbing sheet having a maximum elongation percentage of 30% specifically described in Embodiment 2, the impedance matching was performed in the state of the elongation percentage of 11%, i.e., in the state of the elongation percentage of about 37% as compared with the maximum elongation percentage. The criteria for performing impedance matching in the state of the electromagnetic-wave absorbing sheet being stretched by a predetermined elongation percentage depend on the type of the rubber material used as the binder, particularly, the deformation type of the rubber material when stretched beyond the maximum elongation percentage. However, by setting the criteria to the state of the elongation of 5 to 75 % with respect to the maximum elongation percentage, it is possible to minimize a difference between the input impedance of the electromagnetic-wave absorbing sheet and the impedance in the air in a wide practical range, and prevent the lowering of the electromagnetic-wave absorbing properties due to reflection or scattering of electromagnetic waves entering the electromagnetic-wave absorbing sheet.

From the opposite viewpoint, by maintaining the input impedance of the electromagnetic-wave absorbing sheet close to the impedance in the air of 377Ω within the range of the elastic region, it is possible to obtain an impedance matching effect of a certain level or higher within the practical range of the electromagnetic-wave absorbing sheet, and prevent the electromagnetic-wave absorbing sheet from lowering the electromagnetic-wave absorption amount. According to the study of the present inventors, the numerical range of the input impedance is from 360 Ω to 450 Ω. When the input impedance of the electromagnetic-wave absorbing sheet is smaller than 360 Ω or larger than 450Ω, electromagnetic waves entering the electromagnetic-wave absorbing sheet are greatly scattered or reflected at a boundary surface between a space on the surface of the electromagnetic-wave absorbing sheet and the electromagnetic-wave absorbing sheet, and the electromagnetic-wave absorbing sheet cannot exhibit its electromagnetic-wave absorbing properties.

The fact that the electromagnetic-wave absorbing sheet can favorably absorb electromagnetic waves even when the elongation amount changes, by matching the input impedance of the electromagnetic-wave absorbing sheet to the impedance in the air not in the state where the electromagnetic-wave absorbing sheet is not stretched (i.e., the elongation amount of 0%) but in the state where the electromagnetic-wave absorbing sheet is stretched by 5% to 75% of the maximum elongation percentage, is not limited to the reflection-type electromagnetic-wave absorbing sheet described in Embodiment 2. The same applies to the transmission-type electromagnetic-wave absorbing sheet described in Embodiment 1.

Unlike the reflection-type electromagnetic-wave absorbing sheet of Embodiment 2, the electromagnetic-wave absorbing properties (electromagnetic-wave attenuation amount) of the transmission-type electromagnetic-wave absorbing sheet of Embodiment 1 are not directly affected by the intensity of electromagnetic waves scattered or reflected on the electromagnetic-wave incident side. However, there may be a case where it is desired to reduce reflected waves on the electromagnetic-wave incident side of the transmission-type electromagnetic-wave absorbing sheet for the purpose of, e.g., preventing the leakage of electromagnetic waves to the outside from an electric circuit that can be an electromagnetic-wave emission source while preventing reflected waves on the surface of the electromagnetic-wave absorbing sheet from adversely affecting the electric circuit. In such a case, it is preferable also for the transmission-type electromagnetic-wave absorbing sheet to have an input impedance close to the impedance in the air even when the elongation percentage changes, specifically, it is preferable to set the input impedance to 377Ω based on the state where the electromagnetic-wave absorbing sheet is stretched by 5% to 75% of the maximum elongation percentage.

Also, as illustrated in FIG. 8, in the fourth electromagnetic-wave absorbing sheet, even when the elongation percentage changes and the thickness changes, a frequency of input electromagnetic waves at which the largest absorption amount was exhibited in the electromagnetic-wave absorbing properties in the respective thicknesses was 75.5 GHz. Similarly to the first electromagnetic-wave absorbing sheet described in Embodiment 1, since the electromagnetic-wave absorbing sheet disclosed in the present application absorbs electromagnetic waves entered by the magnetic resonance of the magnetic iron oxide (electromagnetic-wave absorbing material), the frequency of electromagnetic waves at which the largest absorbing properties are exhibited is not affected by the thickness of the electromagnetic-wave absorbing layer, if the electromagnetic-wave absorbing material is the same.

On the other hand, electromagnetic-wave absorbing sheets currently available on the market that can absorb electromagnetic waves of the millimeter-wave band while having elasticity are wavelength-interference type electromagnetic-wave absorbing sheets, which are formed of a stack of a dielectric layer and a reflective layer and attenuate the intensity of reflected waves by shifting the phase of incident electromagnetic waves by a half wavelength. In the wavelength-interference type electromagnetic-wave absorbing sheets, when the thickness of the dielectric layer changes, the wavelength of electromagnetic waves to be absorbed changes. Therefore, when the wavelength-interference type electromagnetic-wave absorbing sheets having elasticity are elongated by a predetermined elongation percentage and change its thickness, a peak frequency of electromagnetic waves to be absorbed changes. As a result, for example, a wavelength-interference type electromagnetic-wave absorbing sheet that is arranged to absorb electromagnetic waves of a specific wavelength (e.g., a vehicle-mounted radar) may lower properties of absorbing electromagnetic waves of a desired frequency due to its elasticity.

The electromagnetic-wave absorbing sheet disclosed in the present application does not have such a problem because there is no change in the frequency of electromagnetic waves to be absorbed most.

(Other configuration)

Embodiments 1 and 2 mainly use epsilon iron oxide as the magnetic iron oxide, which is the electromagnetic-wave absorbing material contained in the electromagnetic-wave absorbing layer. As described above, by using epsilon iron oxide, it is possible to form an electromagnetic-wave absorbing sheet that absorbs electromagnetic waves of 30 GHz to 300 GHz (millimeter-wave band). Further, by using rhodium or the like as the metal material substituting for the Fe site, it is possible to obtain an electromagnetic-wave absorbing sheet that absorbs electromagnetic waves of one terahertz, which is the highest frequency defined as electromagnetic wave.

In the electromagnetic-wave absorbing sheet disclosed in the present application, the magnetic iron oxide to be used as the electromagnetic-wave absorbing material of the electromagnetic-wave absorbing layer is not limited to epsilon iron oxide.

Barium ferrite and strontium ferrite (indicated in part of examples), which are hexagonal ferrites of ferrite electromagnetic absorbers, exhibit favorable electromagnetic-wave absorbing properties with respect to electromagnetic waves in a frequency band of several gigahertz to several tens of gigahertz. Therefore, by forming an electromagnetic-wave absorbing layer using a rubber binder and particles of such a magnetic iron oxide other than epsilon iron oxide that exhibits electromagnetic-wave absorbing properties in the millimeter-wave band from 30 GHz to 300 GHz, it is possible to produce an electromagnetic-wave absorbing sheet that absorbs electromagnetic waves in the millimeter-wave band while having elasticity.

For example, hexagonal ferrite particles have a larger particle size (about several $\mu$m) than epsilon iron oxide particles exemplified in the above embodiments, and the shape of the hexagonal ferrite particles is not substantially spherical but plate or needle crystal. Therefore, in the formation of the magnetic coating material using the rubber binder, it is preferable to control the use of the dispersant and the kneading conditions with the binder so that, when the magnetic coating material is applied, the magnetic iron oxide powder is dispersed as uniformly as possible in the electromagnetic-wave absorbing layer and the percentage of voids is as low as possible.

As to the electromagnetic-wave absorbing sheets described in the embodiments, the use of the rubber binder as the binder constituting the electromagnetic-wave absorbing layer makes it possible to provide an electromagnetic-wave absorbing sheet having elasticity. Further, the use of the magnetic iron oxide that magnetically resonates in a frequency band equal to or higher than the millimeter-wave band as the electromagnetic-wave absorbing material makes it possible to provide an electromagnetic-wave absorbing sheet that absorbs electromagnetic waves of high frequencies while having elasticity.

In the case of the electromagnetic-wave absorbing sheet that contains, as the electromagnetic-wave absorbing material, a magnetic iron oxide that absorbs electromagnetic waves by magnetic resonance, a higher electromagnetic-wave absorbing effect can be obtained by increasing the volume content of the electromagnetic-wave absorbing material in the electromagnetic-wave absorbing sheet. However, in the electromagnetic-wave absorbing sheet including the electromagnetic-wave absorbing layer constituted by the rubber binder and the electromagnetic-wave absorbing material, there naturally is an upper limit in the volume content of the electromagnetic-wave absorbing material in terms of obtaining elasticity using the binder. By setting the volume content of the magnetic iron oxide (electromagnetic-wave absorbing material) in the electromagnetic-wave absorbing layer to be 30% or more, the electromagnetic-wave absorbing sheet disclosed in the present application, in particular, the reflection-type electromagnetic-wave absorbing sheet, can achieve the reflection attenuation amount of -15 dB or more.

It is preferred that the volume content of the rubber binder in the electromagnetic-wave absorbing layer is 40% to 70%. By setting the volume content of the rubber binder within this range, it becomes easy to set the maximum elongation percentage of the elastic region in one in-plane direction of the electromagnetic-wave absorbing sheet to be a desired range of 20% to 200%.

The above description explains, as a method for forming the electromagnetic-wave absorbing layer, the method including preparing a magnetic coating material, and applying and drying the magnetic coating material. Other than the method of applying the magnetic coating material described above, the production method of the electromagnetic-wave absorbing sheet disclosed in the present application may be, e.g., an extrusion molding method.

More specifically, magnetic iron oxide powder, a rubber binder, and as needed a dispersant and the like are blended in advance, and the blended materials are supplied from a resin supply port of an extrusion molding machine into a plasticizing cylinder. The extrusion molding machine may be an ordinary extrusion molding machine that includes a plasticizing cylinder, a die provided at the tip of the plasticizing cylinder, a screw rotatably disposed in the plasticizing cylinder, and a driving mechanism that drives the screw. The material molten by a band heater of the extrusion molding machine is fed forward by the rotation of the screw and extruded into a sheet shape from the tip. The extruded material is subjected to drying, pressure molding, calendering, and the like to obtain an electromagnetic-wave absorbing layer having a predetermined thickness.

The method for forming the electromagnetic-wave absorbing layer may be a method including preparing a magnetic compound containing magnetic iron oxide powder and a rubber binder, and subjecting the magnetic compound to press molding in a predetermined thickness.

Specifically, first, a magnetic compound as an electromagnetic-wave absorbing composition is prepared. The magnetic compound can be obtained by mixing and kneading magnetic iron oxide powder and a rubber binder, and mixing a crosslinking agent into the obtained kneaded mixture to adjust the viscosity.

In one example, the magnetic compound as the electromagnetic-wave absorbing composition thus obtained is subjected to crosslinking and molding into a sheet at a temperature of, e.g., 170°C using a hydraulic pressing machine. Then, the sheet is subjected to secondary crosslinking in a thermostat at a temperature of 170°C. Thus, an electromagnetic-wave absorbing sheet having a predetermined shape can be obtained.

In the above embodiment, although the electromagnetic-wave absorbing layer of the electromagnetic-wave absorbing sheet is constituted by a single layer, it may be constituted by a plurality of stacked layers. The electromagnetic-wave absorbing properties of the transmission-type electromagnetic-wave absorbing sheet in Embodiment 1 improve by giving the electromagnetic-wave absorbing layer a certain thickness. The electromagnetic-wave absorbing properties of the reflection-type electromagnetic-wave absorbing sheet in Embodiment 2 can improve further by adjusting the thickness of the electromagnetic-wave absorbing layer to match the input impedance of the electromagnetic-wave absorbing layer to the impedance in the air. If an electromagnetic-wave absorbing layer cannot have a predetermined thickness by a single layer due to the properties of the electromagnetic-wave absorbing material and the binder constituting the electromagnetic-wave absorbing layer, it is effective to form an electromagnetic-wave absorbing layer as a stack.

Industrial Applicability

The electromagnetic-wave absorbing sheet disclosed in the present application is useful as an electromagnetic-wave absorbing sheet that absorbs electromagnetic waves in a high frequency band equal to or higher than the millimeter-wave band while having elasticity.

Description of Reference Numerals

1    electromagnetic-wave absorbing layer
1a   epsilon iron oxide (magnetic iron oxide)
1b   rubber binder
2    adhesive layer
3    reflective layer

**Claims**

**1.** An electromagnetic-wave absorbing sheet comprising an electromagnetic-wave absorbing layer (1) that contains a magnetic iron oxide (la) that magnetically resonates in a frequency band equal to or higher than a millimeter-wave band as an electromagnetic-wave absorbing material and a rubber binder (lb), **characterized in that** the electromagnetic-wave absorbing sheet has a maximum elongation percentage of an elastic region in one in-plane direction of 20% to 200%, and

an input impedance of the electromagnetic-wave absorbing layer (1) when stretched within a range of the elastic region is in a range from 360 Ω to 450 Ω.

**2.** The electromagnetic-wave absorbing sheet according to claim 1, wherein the magnetic iron oxide (la) is epsilon iron oxide.

**3.** The electromagnetic-wave absorbing sheet according to claim 2, wherein part of a Fe site of the epsilon iron oxide (la) is substituted with a trivalent metal atom.

**4.** The electromagnetic-wave absorbing sheet according to any of claims 1 to 3, wherein a volume content of the magnetic iron oxide (la) in the electromagnetic-wave absorbing layer (1) is 30% or more.

**5.** The electromagnetic-wave absorbing sheet according to any of claims 1 to 4, wherein the rubber binder (1b) is acrylic rubber or silicone rubber.

**6.** The electromagnetic-wave absorbing sheet according to any of claims 1 to 5, wherein an input impedance of the electromagnetic-wave absorbing layer (1) in a state of being stretched by 5% to 75 % of the maximum elongation percentage of the elastic region is matched to an impedance in the air.

**7.** The electromagnetic-wave absorbing sheet according to any of claims 1 to 6, further comprising a reflective layer (3) that is formed in contact with one surface of the electromagnetic-wave absorbing layer (1) to reflect electromagnetic waves passing through the electromagnetic-wave absorbing layer (1).

**8.** The electromagnetic-wave absorbing sheet according to any of claims 1 to 7, further comprising an adhesive layer (2) to make the electromagnetic-wave absorbing sheet attachable.

**9.** An electromagnetic-wave absorbing sheet, comprising:

an electromagnetic-wave absorbing layer (1) containing an electromagnetic-wave absorbing material and a rubber binder (lb), the electromagnetic-wave absorbing material being a magnetic iron oxide (la) that magnetically resonates
with electromagnetic waves of a predetermined frequency; and
**characterized in that** it further comprises
a reflective layer (3) that is formed in contact with one surface of the electromagnetic-wave absorbing layer (1) to reflect electromagnetic waves passing through the electromagnetic-wave absorbing layer (1),
and wherein an input impedance of the electromagnetic-wave absorbing layer (1) in a state of being stretched in one in-plane direction is matched to an impedance in the air.

**Patentansprüche**

**1.** Elektromagnetische-Wellen-Absorptionsfolie mit einer elektromagnetische Wellen absorbierenden Schicht (1), die als ein elektromagnetische Wellen absorbierendes Material ein magnetisches Eisenoxid (la), das in einem Frequenzband gleich oder höher als ein Millimeterwellenband magnetisch schwingt, und einen Kautschuk-Binder (1b) beinhaltet,

**dadurch gekennzeichnet, dass** die Elektromagnetische-Wellen-Absorptionsfolie eine maximale prozentuale Dehnung einer elastischen Region in einer Richtung in der Ebene von 20% bis 200% aufweist, und eine Eingangsimpedanz der elektromagnetische Wellen absorbierenden Schicht (1), wenn innerhalb eines Bereiches der elastischen Region gedehnt, in einem Bereich von 360 Ω bis 450 Ω liegt.

2. Elektromagnetische-Wellen-Absorptionsfolie gemäß Anspruch 1, wobei das magnetische Eisenoxid (Ia) epsilon-Eisenoxid ist.

3. Elektromagnetische-Wellen-Absorptionsfolie gemäß Anspruch 2, wobei ein Teil der Fe-Plätze des epsilon-Eisenoxids (Ia) mit einem trivalenten Metallatom substituiert ist.

4. Elektromagnetische-Wellen-Absorptionsfolie gemäß einem der Ansprüche 1 bis 3, wobei ein Volumenanteil des magnetischen Eisenoxids (Ia) in der elektromagnetische Wellen absorbierenden Schicht (1) 30% oder mehr beträgt.

5. Elektromagnetische-Wellen-Absorptionsfolie gemäß einem der Ansprüche 1 bis 4, wobei der Kautschuk-Binder (1b) Acrylkautschuk oder Silikonkautschuk ist.

6. Elektromagnetische-Wellen-Absorptionsfolie gemäß einem der Ansprüche 1 bis 5, wobei eine Eingangsimpedanz der elektromagnetische Wellen absorbierenden Schicht (1) im um 5% bis 75 % der maximalen prozentualen Dehnung der elastischen Region gedehnten Zustand an eine Impedanz an der Luft angepasst ist.

7. Elektromagnetische-Wellen-Absorptionsfolie gemäß einem der Ansprüche 1 bis 6, ferner aufweisend eine reflektive Schicht (3), die in Kontakt mit einer Oberfläche der elektromagnetische Wellen absorbierenden Schicht (1) zum Reflektieren von durch die elektromagnetische Wellen absorbierenden Schicht (1) tretenden elektromagnetischen Wellen ausgebildet ist.

8. Elektromagnetische-Wellen-Absorptionsfolie gemäß einem der Ansprüche 1 bis 7, ferner aufweisend eine adhäsive Schicht (2) zum Anbringbar-Machen der Elektromagnetische-Wellen-Absorptionsfolie.

9. Elektromagnetische-Wellen-Absorptionsfolie, mit:
einer elektromagnetische Wellen absorbierenden Schicht (1), enthaltend ein elektromagnetische Wellen absorbierendes Material und einen Kautschuk-Binder (Ib), wobei das elektromagnetische Wellen absorbierende Material ein magnetisches Eisenoxid (Ia) ist, das mit elektromagnetischen Wellen einer vorbestimmten Frequenz mitschwingt; und ferner **dadurch gekennzeichnet, dass** es ferner eine reflektive Schicht (3) aufweist, die in Kontakt mit einer Oberfläche der elektromagnetische Wellen absorbierenden Schicht (1) ausgebildet ist, um elektromagnetische Wellen zu reflektieren, die durch die elektromagnetische Wellen absorbierende Schicht (1) treten, und wobei eine Eingangsimpedanz der elektromagnetische Wellen absorbierenden Schicht (1) in einem in eine Richtung in der Ebene gedehnten Zustand an eine Impedanz in der Luft angepasst ist.

**Revendications**

1. Feuille d'absorption d'ondes électromagnétiques comprenant une couche d'absorption d'ondes électromagnétiques (1) qui contient un oxyde de fer magnétique (Ia) qui résonne magnétiquement dans une bande de fréquences égale ou supérieure à une bande d'ondes millimétriques en tant que matériau d'absorption d'ondes électromagnétiques et un liant en caoutchouc (1b), **caractérisé en ce que** la feuille d'absorption d'ondes électromagnétiques présente un pourcentage d'allongement maximal d'une région élastique dans une direction dans le plan de 20 % à 200 %, et une impédance d'entrée de la couche d'absorption d'ondes électromagnétiques (1) lorsqu'elle est étirée dans une plage de la région élastique se trouve dans une plage de 360 Ω à 450 Ω.

2. Feuille d'absorption d'ondes électromagnétiques selon la revendication 1, l'oxyde de fer magnétique (Ia) étant de l'oxyde de fer d'Epsilon.

3. Feuille d'absorption d'ondes électromagnétiques selon la revendication 2, une partie d'un site Fe de l'oxyde de fer d'Epsilon (Ia) étant remplacée par un atome de métal trivalent.

4. Feuille d'absorption d'ondes électromagnétiques selon l'une quelconque des revendications 1 à 3, une teneur en volume de l'oxyde de fer magnétique (1a) dans la couche d'absorption d'ondes électromagnétiques (1) étant égale ou supérieure à 30 %.

5. Feuille d'absorption d'ondes électromagnétiques selon l'une quelconque des revendications 1 à 4, le liant en caoutchouc (1b) étant du caoutchouc acrylique ou du caoutchouc de silicone.

6. Feuille d'absorption d'ondes électromagnétiques selon l'une quelconque des revendications 1 à 5, une impédance d'entrée de la couche d'absorption d'ondes électromagnétiques (1) dans un état d'étirage de 5 % à 75 % du pourcentage d'allongement maximal de la région élastique étant adaptée à une impédance dans l'air.

7. Feuille d'absorption d'ondes électromagnétiques selon l'une quelconque des revendications 1 à 6, comprenant en outre une couche réfléchissante (3) qui est formée en contact avec une surface de la couche d'absorption d'ondes électromagnétiques (1) pour réfléchir les ondes électromagnétiques passant à travers la couche d'absorption d'ondes électromagnétiques (1).

8. Feuille d'absorption d'ondes électromagnétiques selon l'une quelconque des revendications 1 à 7, comprenant en outre une couche adhésive (2) pour rendre la feuille d'absorption d'ondes électromagnétiques attachable.

9. Feuille d'absorption d'ondes électromagnétiques, comprenant :

une couche d'absorption d'ondes électromagnétiques (1) contenant un matériau d'absorption d'ondes électromagnétiques et un liant en caoutchouc (1b), le matériau d'absorption d'ondes électromagnétiques étant un oxyde de fer magnétique (1a) qui résonne magnétiquement avec des ondes électromagnétiques d'une fréquence prédéterminée ; et
**caractérisé en ce qu'**il comprend en outre
une couche réfléchissante (3) qui est formée en contact avec une surface de la couche d'absorption d'ondes électromagnétiques (1) pour réfléchir les ondes électromagnétiques passant à travers la couche d'absorption d'ondes électromagnétiques (1),
et
une impédance d'entrée de la couche d'absorption d'ondes électromagnétiques (1) dans un état d'étirage dans une direction dans le plan étant adaptée à une impédance dans l'air.

FIG. 1

FIG. 2

FIG. 3A

FIG. 3B

FIG. 4

FIG. 5

FIG. 6

FIG. 7

FIG. 8

FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008060484 A
- JP 2016135737 A
- JP 2011233834 A
- JP 2005057093 A
- JP 2013004854 A
- US 2010238063 A1
- JP 2004186371 A
- JP 502 A